(19) Europäisches Patentamt
European Patent Office
Office européen des brevets

(11) EP 0 570 094 B1

(12) **EUROPEAN PATENT SPECIFICATION**

(45) Date of publication and mention
of the grant of the patent:
**24.06.1998   Bulletin 1998/26**

(51) Int Cl.6: **H05K 3/46**, H05K 3/00,
G03F 7/027

(21) Application number: **93301724.6**

(22) Date of filing: **08.03.1993**

(54) **Method of forming a multilayer printed circuit board and product thereof**

Verfahren zur Herstellung einer mehrschichtigen Leiterplatte und daraus erhaltenes Produkt

Méthode pour former une plaque à circuits imprimés multicouche et produit

(84) Designated Contracting States:
**BE DE ES FR GB IT NL SE**

(30) Priority: **15.05.1992   US 883436**

(43) Date of publication of application:
**18.11.1993   Bulletin 1993/46**

(73) Proprietor: **Morton International, Inc.**
**Chicago, Illinois 60606-1596 (US)**

(72) Inventors:
• **Rath, James**
**Orange, CA 92669 (US)**
• **Flynn, Kathy M.**
**Tustin, CA 92680 (US)**
• **Tran, William Luong-Gia**
**Garden Grove, CA 92641 (US)**

• **Tara, Vinai Ming**
**Anaheim, CA 92804 (US)**

(74) Representative:
**Bankes, Stephen Charles Digby et al**
**BARON & WARREN**
**18 South End**
**Kensington**
**London W8 5BU (GB)**

(56) References cited:
**EP-A- 0 283 990          US-A- 4 476 215**

• **PATENT ABSTRACTS OF JAPAN vol. 9, no. 26**
**(P-332) 5 February 1985 & JP-A-59 171 948**
**(SONY) 28 September 1984**

## Description

The present invention is directed to a method for forming a multilayer printed circuit board, and more particularly to a method of forming a multilayer printed circuit board in which a photoimageable composition used to print the individual innerlayers forms substantially all of the dielectric material separating the innerlayers from each other.

Multilayer printed circuit boards comprise a stack of individual printed circuit boards or innerlayers separated by dielectrical material. The circuitry of the several innerlayers is electrically connected by bored and plated- through holes. Multilayer printed circuit boards provide circuitry in a three-dimensional array and are therefor advantageously space-saving, relative to individual printed circuit boards, which provide at most two layers of circuitry on a two-sided board.

These printed circuit boards are commonly provided with internal ground and power planes. These internal planes are frequently solid sheets of copper interrupted only by clearance holes (the perforations required for electrically isolating the through hole pattern of the printed circuit board). Ground and power planes provide power voltage and current and ground connections for the components of the multilayer printed circuit. A second function of the ground and power planes is to provide electromagnetic shielding for the multilayer printed circuit board and reduce the electromagnetic and radio frequency interference. Multiple ground and power planes and additional ground planes on the surface layers with the conductive pattern are common.

When components are mounted on a multilayer printed circuit board and mass soldered in place at temperatures on the order of about 275°C (527°F), a severe thermal shock is applied to the insulating layers placed between two copper planes, such as the insulating layer between an internal ground plate and ground shield on the surface surrounding the conductor pattern. Frequently, delamination will occur and blisters will form between the ground shield on the surface and the internal ground or power plane. Delamination and blistering have been a problem with multilayers made by a fully additive, semi-additive, or subtractive sequential processes.

In a conventional subtractive procedure for forming multilayer printed circuit boards, the innerlayers are formed in the manner of individual two-sided printed circuit boards. A blank board formed of epoxy that is covered on each side with a metal layer, such as copper, is coated on each side with a layer of primary photoresist. The primary photoresist may be coated as a liquid resist or applied as a dry film. The layers of photoresist are exposed to patterned actinic radiation by placing artwork over the photoresist layers and directing light through the artwork to the photo- resist layers. Subsequently, the exposed photoresist layers are developed in an appropriate aqueous medium to remove exposed or unexposed portions of the photoresist layers, depending upon whether the photoresist is positive-acting or negative-acting. The metal layer is then etched away in the areas from which the overlying photoresist has been removed. After etching, the remaining portions of the photoresist layers are stripped from the surfaces of the board. In the conventional procedure, the copper surfaces which have been uncovered by the stripping process are then treated to enhance adhesion of the copper to the pre-preg in subsequent steps.

The individual innerlayers are stacked with alternating layers of "prepreg" material, which typically comprises an epoxy/fiberglass composition. The assembly of innerlayers and prepregs is then pressed together and heated. The pre-preg material initially flows under the heat and pressure, filling the voids between the innerlayers, and eventually cures under these conditions to form a hard permanent dielectric material separating the individual circuitry layers.

It has been the practice to apply an initial, strongly adherent oxide layer to the copper to enhance the bond between the copper conductive patterns and the insulating layers. The oxide layers are usually applied by immersing the copper surface in hot (40°-110°C), strongly alkaline, hypochlorite solutions. This immersion produces a black, dendritic oxide layer with a high surface area for adhering to organic films, coatings, and laminated layers. In the printed circuit industry, this oxide is commonly called "black oxide".

To electrically connect the circuitry of the several innerlayers, holes are drilled through the cured assembly. The heat so generated causes an epoxy resin "drill smear" on the inner layer copper surface around the drilled hole prior to the electroless plating of the hole wall. The hole walls are plated to create electrical connections to the inner copper planes. The desmearing and plating solutions dissolve the black oxide surrounding the holes and leave non-adherent rings around the holes. This is known as "pink ring" because of the ring of copper visible in the pattern of black oxide. At the pink ring, there is no adhesion between the copper plane and the laminated insulating layer over it. Ionic contamination and the failure of insulation between holes occur where pink ring is found.

As can be seen, the above process requires a number of steps.

The present invention consists in a process for fabricating a multilayer printed circuit board comprising the steps of:

(A) providing a plurality of innerlayer boards each comprising a dielectric base and having at least one metal layer thereon;

(B) coating each of said metal layers with a layer of photoimageable composition which photoimageable composition is curable to form a hard, permanent, dielectric material, and which comprises:

(a) from 10 to 40% by weight of said polymerizable acrylate monomer;

(b) from 5 to 35% by weight of an oligomer formed by the reaction of an epoxy resin and acrylic or methacrylic acid;

(c) a photosensitive, free radical generating initiator for polymerization of the acrylate monomer and oligomer;

(d) a curable epoxy resin;

(e) a curing agent for the epoxy resin; and

(f) from 0% to 15% weight of a cross-linking agent reactive with hydroxyl groups, all based on the total weight of components (a) through (f);

(C) exposing each of said layers of photoimageable material with patterned actinic radiation;

(D) developing said exposed layers to remove either exposed or non-exposed portions, leaving non-exposed or exposed portions of said photoimageable composition layers on said metal layers;

(E) etching said metal layers of said innerlayer boards to remove portions of said metal layers from which said photoimageable composition layer portions were removed; and

(F) without removing remaining portions of said photoimageable composition from said etched metal layers, stacking said innerlayer boards and subjecting said boards to heat and pressure so that said photoimageable composition initially fills voids between the innerlayer boards at least partially and then cures to form hard, permanent, dielectric layers separating circuitry of adjacent innerlayers.

By means of the invention multilayer printed circuit boards can be produced utilizing fewer production steps, without the need for an oxide treatment of the copper layers to improve their adhesion to the epoxy/fibreglass substrate.

It is also possible by means of this invention to eliminate pink ring on the innerlayers of a multilayer printed circuit board and wedge voids caused by the action of desmearing chemicals at the black oxide/epoxy interface on the innerlayers.

In the resulting multilayered printed circuit board the prepreg dielectric material is substantially replaced by a permanent innerlayer of photoresist material. The permanent innerlayer resists can be made very thin and can be imaged on contact with enhanced printing resolution capabilities.

The resulting multilayer printed circuit boards have improved resolution of the circuitry images thereon.

The process of the invention makes it possible to reduce the materials used and to minimize toxic wastes that normally result from the process.

In accordance with the present invention, the boards to be used as innerlayers of a multilayer printed circuit board are formed using a resist that is not only photoimageable but is hardenable to form a permanent dielectric material. The individual innerlayers can be printed in a conventional manner. A board of dielectric base material, such as a glass fiber reinforced epoxy resin, having a layer of copper on each side thereof is covered on both sides with a hardenable photoimageable resist. The resist may be applied by a variety of methods such as screen printing, electrostatic spray coating, spin coating, curtain coating, or as a layer or laminate of dry film. The resist is then exposed to patterned actinic radiation and developed in an appropriate developer to remove either the exposed or non-exposed portions of the photoresist. Next, the processed board is subjected to an etch that removes the metal layers from those regions where the resist has been removed. The resist, rather than being stripped after exposure, development and etching, is left on the innerlayers as a supplement for or replacement of the prepregs normally used to form dielectric layers between the innerlayers. In the manner of prepregs, the photoimageable composition layer, under heat and pressure, initially conforms to the contours of the innerlayers, filling in the voids between the innerlayers, and subsequently cures to form at least a portion of permanent dielectric layers separating the circuitry of the individual innerlayers. The multilayer board is completed in a normal manner by boring holes through the cured assembly and lining the bored holes with metal.

Preferred embodiments of the invention will now be described with reference to the accompanying drawings in which:

Figure 1 is an elevation of an assembly of exposed, developed and etched innerlayers of this invention between two outerlayers as they are about to be pressed to form a multilayer printed circuit board in accordance with the present invention.

Figure 2 is an elevation of a multilayer board made from the assembly of Figure 1.

As described above, the photoimageable composition is applied as a layer to the copper clad substrate (or to a support sheet to form a dry film which is then laid on the copper). After application, the wet layer is dried to remove organic solvent. During this drying, some reaction of components may occur, particularly between an anhydride and a melamine-formaldehyde resin. After drying, the photoimageable layer is exposed to patterned actinic radiation at an energy level sufficient to cause enough crosslinking to prevent attack by the aqueous alkaline developer that follows in the conventional process. It is preferred to effect a UV cure at an energy level of from about 1 to about 4 joules/cm$^2$ to tie up any unreacted acrylate prior to lamination and preferably after etching of the copper exposed by the developer. Prior to the heat cure of the photoresist composition that occurs during the pressing of the innerlayers which is described below, i.e., prior to activation of the epoxy chemical system, the layer of photoimageable compositions remains strippable by common strippers in the event that a need to remove the layer for reworking arises.

The ability to be developed with aqueous or alkaline aqueous solutions is an important advantage of the photoimageable composition used in the process of the present invention. Eliminating the need for solvent-based developers eliminates the cost of the solvents as well as health, environmental and recycling problems. Although the films formed in accordance with the process of the invention are developable in aqueous solutions without any organic solvents, developers may include some organic solvents, providing that the added organic solvent does not solubilize the exposed portions of the film.

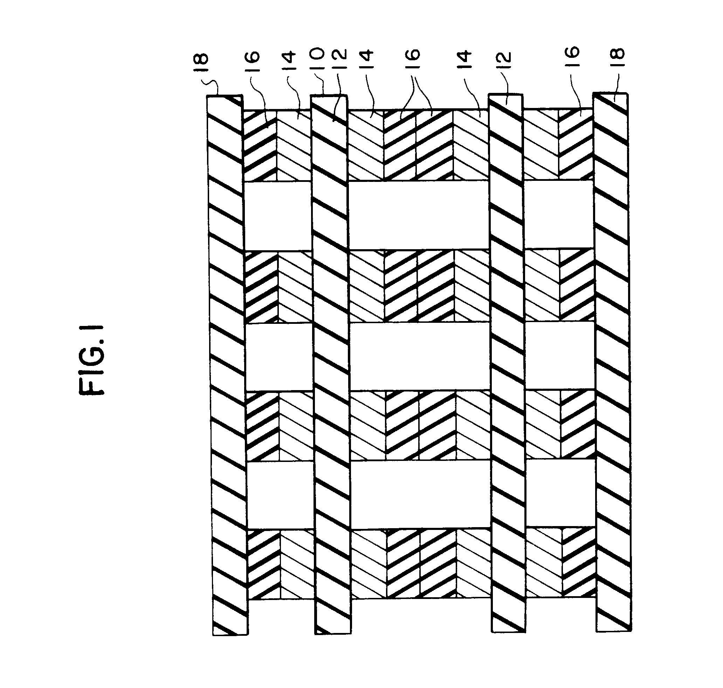

In Figure 1 of the drawings, each innerlayer 10 comprises a base layer 12 of dielectric material, circuitry traces 14 on the opposite faces thereof, and the photoimageable composition 16 overlying the circuitry traces 14. Although not shown here for the sake of clarity, the outerlayers 18 may have circuitry traces on their inner faces, only, before pressing of the assembly; the outer faces thereof would still retain a bare layer of copper foil which may be coated with resist, exposed, developed, and etched after the multilayered board comes out of the press.

In the prior art method of forming a multilayer circuit board, the photoimageable composition used instead of composition 16 would have been stripped from the circuitry traces 14 and the exposed circuitry traces would have been treated in a chemical bath. In the process of the present invention, the photoimageable composition 16 is not stripped. The need for a stripper is eliminated, as are any problems associated with disposal of the stripper.

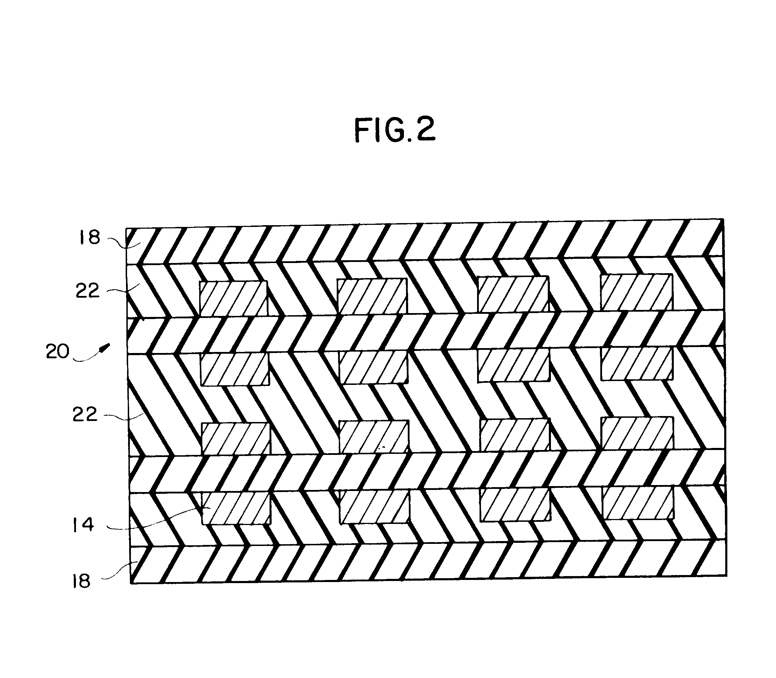

At this point, there are several options available in forming the multilayer circuit board. In the option shown in Figures 1 and 2, the innerlayers 10 and outerlayers 18 are merely stacked in a standard multilayer press and the assembly is subjected to heat and pressure which initially squeezes the still flowable photoimageable composition 16 into the voids between the innerlayers 10 to form the board 20 of Figure 2. The board 20 is maintained under heat and pressure for from about 3 to about 3.6 hours, during which time the photoimageable composition 16 cures to form hardened, permanent dielectric layers 22 which electrically separate the circuitry traces 14 of the innerlayers 10.

The conditions of heat and pressure are somewhat dependent upon the particular photoimageable composition selected for the process. In a suitable procedure known as the hot start/dual pressure procedure or the "kiss" procedure, the assembly is held at about 350°F (177°C) at about 345 kPa (50 psi) for a short while and then the pressure is increased to from 3.1 to 4.8 MPa (450 to 700 psi). In the hot start/full pressure procedure, the temperature is 177°C (350°F) but a pressure of from 4.1 to 5.5 MPa (600 to 800 psi., 56 kg/cm$^2$) is held for the full 3 to 3.6 hours. The cured assembly is suitably cooled down at a rate of about 5.6°C/min (10°F/min). An optional postbake of the dielectric layers 22 may be used to further cure or anneal it.

The option of utilizing only the photoimageable composition to form the dielectric layer 22 has the advantage of eliminating any need for prepregs or additional material, the inclusion of which would constitute additional effort. On the other hand, if only the photoimageable composition 16 is to be used to form the dielectric layers 22, it must be applied relatively thickly in order that the portions of the photoimageable composition 16 remaining after development provide sufficient material to not only fill in the voids between the traces 14 but also to provide a sufficiently thick dielectric barrier between the traces of adjacent innerlayers 10. Because the photoimageable composition is relatively expensive, thick layers of it are expensive to produce. Also, a thick photoimageable layer produces poorer resolution than a thin one. If the initially applied photoimageable layers are to serve as the sole source of material for the dielectric layer 22, the thickness of the photoimageable layer will vary from 12.7 to 81.3 µm (0.5 mil to 3.2 mils).

Another option (not illustrated) is to apply additional dielectric prepreg material to the board after etching. Again, the photoimageable composition layer is not removed from the traces, avoiding the need for stripper and treatment to avoid oxidation. The additional material could be more of the photoimageable composition 16, a compatible curable system (without the photosensitive components to minimize cost), or even conventional prepregs. In any case, the photoimageable composition layer that is left on the traces forms a portion of the dielectric layers 22 in the multilayer board.

The board 20 is then taken out of the press, the outerlayers are processed as desired and the resulting multilayer board is then processed in a conventional manner. Holes are bored through the layers, and the hole walls are plated to electrically connect the circuitry of the several layers.

The composition 16 used in the process according to the present invention includes an acrylic chemical system by which the composition is photo-polymerized and an epoxy chemical system which is curable to harden the composition after exposure and development. The two chemical systems, however, are not exclusive of each other and components of the two chemical systems are believed to interact chemically with each other. This is especially true when the composition includes a cross-linking agent (f).

The acrylic system includes the acrylate monomers (a), the epoxy-acrylate oligomer (c) and the photoinitiator (b). The epoxy system includes the epoxy resin (d) and the acidic curative (e) therefor. If a cross-linking agent (f) is used, it is selective to be reactive with free hydroxyl groups of components of both the acrylic and epoxy systems.

In one embodiment of the invention, the preferred photo-imageable composition comprises (a) from about 10 to about 40% of the acrylate monomers; (b) from about 3 to about 15% photo initiator; (c) from about 5 to about 35% of an epoxy-acrylate oligomer; (d) from about 20 to about 80% of an epoxy resin; (e) from about 0.1 to about 10% of an acidic curative for the epoxy resin and; (f) from about 2 to about 15 % of the cross-linking agent. The preferred composition has a photo-sensitive chemical system which renders exposed portions of the resist insoluble in alkaline aqueous developer and an epoxy-based chemical system which is curable to provide permanence and hardness to the material subsequent to exposure, development, etching and curing.

A level of the acrylate monomer (a) lower than 10 % may be insufficient to insolubilize the portions of the photoresist layer that have been exposed to actinic radiation. Levels of acrylate monomer higher than 40 % may result in an innerlayer which is too soft. The acrylate monomer preferably comprises from about 15 to about 35 percent of the total weight of components (a)-(f). Unless otherwise stated, all percentages of components (a)-(f) are calculated relative to the total weight of components (a)-(f). The amounts of any additional ingredients, such as fillers, solvents, etc. are also calculated relative to the sum of the weights of (a)-(f). The dried composition of (a)-(f) is soluble in alkaline aqueous solution, whereby the photoimageable composition layer 16 on a circuit laminate is developable with alkaline aqueous solution.

The acyl moiety of the acrylate monomers is represented by the formula: $[RCH=CHC=O]_x$ wherein R is hydrogen or alkyl, and x is an integer from 1 to 4. The monomers are selected from a variety of esters of acrylic and methacrylic acids, such as methyl acrylate, methyl methacrylate, hydroxyethyl acrylate, butyl methacrylate, octyl acrylate, 2-ethoxy ethyl methacrylate, t-butyl acrylate; 1,5-pentanediol diacrylate, N,N-diethylaminoethyl acrylate, ethylene glycol diacrylate; 1,4-butanediol diacrylate, diethylene glycol diacrylate, hexamethylene glycol diacrylate; 1,3-propanediol diacrylate, decamethylene glycol diacrylate, decamethylene glycol dimethacrylate; 1,4-cyclohexanedioldiacrylate; 2,2-dimethylol propane diacrylate, glyceroldiacrylate, tripropylene glycol diacrylate, glycerol triacrylate, trimethylolpropane triacrylate, pentaerythritol triacrylate; 2,2-di(p-hydroxy-phenyl)-propane diacrylate, pentaerythritol tetracrylate; 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylolpropane triacrylate, ethylene glycol dimethacrylate, butylene glycol dimethacrylate; 1,3-propanediol dimethacrylate; 1,2,4-butanetriol trimethacrylate; 2,2,4-trimethyl-1,3-pentanediol dimethacrylate, pentaerythritol trimethacrylate; 1-phenyl-ethylene-1,2-dimethacrylate, pentaerythritol tetramethacrylate, trimethylol propane trimethacrylate; 1,5-pentanediol dimethacrylate; 1,4-benzenediol dimethacrylate, and the triacrylate of tris-(2-hydroxyethyl) isocyanurate. Polyfunctional acrylates and methacrylates, i. e., those having three or more acrylic or methacrylic moieties, are preferred because of the increased photospeed gained by their presence.

By epoxy-acrylate oligomer (c) is meant, herein, an oligomer formed from an epoxy backbone which is reacted with acrylic or methacrylic acid, a low molecular weight polyacrylic or polymethacrylic acid, or a mixture of them, so that at least about 90% of the epoxy groups are esterified with the acid. In the reaction of the acid with the epoxy groups of the epoxy resin, the acid molecules each form an ester bond with the resin and a hydroxyl group is formed on the vicinal carbon atom. Because substantially all of the epoxy groups are reacted with the acrylic or methacrylic acid moiety, the oligomer functions primarily as an acrylate or methacrylate, said moieties of the oligomer polymerizing along with the acrylic monomers during the photoinitiated reaction which renders exposed portions of the photoimageable composition layer insoluble to aqueous alkaline solution. The substantial hydroxyl functionality provides the basis for cross-linking with the cross-linking agent (f), if such a cross-linking agent (f) is used.

Preferred epoxy-acrylate oligomers are diacrylate (or methacrylate) esters of bisphenol A type resins, novolac resins, and mixtures thereof having a maximum epoxide content of about 0.5 % by weight. These oligomers are developed to combine good UV/EB cure response along with the chemical resistance and 'durability of the epoxy resins. Said oligomers are derived from bisphenol A resins having a functionality of two so they also have a functionality of two.

The synthesis of polyfunctional acrylate resins and other unsaturated esters from the corresponding epoxy derivatives is described in the following U.S. patents: 3,256,226; 3,317,465; 3,345,401; 3,373,221; 3,377,406; 3,432,478; 3,548,030; 3,564,074; 3,634,542 and 3,637,618.

The epoxy-acrylate oligomer preferably comprises from 5 to 25 % of the total weight of components (a)-(f), and more preferably from 12 to 18 %. Epoxy-acrylate oligomers used in the photoimageable composition preferably have molecular weights of from 500 to 2000.

Also required in conjunction with the polymerizable acrylate substance is a chemical initiator system which generates free radicals in the presence of actinic radiation and thereby causes the polymerization of the acrylic substances. Polymerization of acrylic monomers and acrylic moieties of the epoxy-acrylate oligomers into a three dimensional structure insolubilizes the photoimageable composition. The choice of the photosensitive, free radical generating initiator system is not considered to be critical to the practice of the present invention, and a wide variety of such compounds may be successfully utilized in the practice of this invention. Examples of chemical photoinitiator systems include benzophenone, benzoin ether, benzil ketals and acetophenone and its derivatives. Other suitable initiator systems are described, for example, in U.S. Patent Nos. 3,469,982, 4,451,523 and 4,358,477. The amount of photoinitiator employed may vary over a wide range, depending upon the polymerizable acrylic substances, the particular photoinitiator system and the desired time of development. Generally, the photoinitiator chemical system comprises from 3 to 15 % of the total weight of components (a)-(f).

The material which imparts the excellent hardness and durability to the film or layer after development and final curing is the epoxy resin or mixture of epoxy resins. The epoxy resin or resins generatus comprise from 20 to 80 % (preferably from 30 to 60 %) of the total weight of components (a)-(f). At high temperatures and/or in the presence of a catalyst, the epoxy groups of the resin molecules open and react with other materials present. Primarily, the epoxy resin molecules react with the acidic curative (e); however, to a certain extent, the epoxy molecules react during final curing with the cross-linking agent (f), and perhaps also with the photo-polymerized acrylic material and any remaining unpolymerized acrylate monomers or moieties. Preferably, the epoxy resin or mixture of resins is solid at about room temperature. The photoimageable composition can be applied as a liquid film to the substrate after dissolving the solid epoxy resin in the solvent-based mixture first.

A wide variety of epoxy resins is suitable for use in accordance with the present invention. Typically, epoxies of the Bisphenol A and novalac type are used. Other suitable epoxy resins are described, for example, in US-A-4,092,443. Cycloaliphatic epoxides, such as those sold under the trade names Cyanacure UVR-6100 and UVR-6110 by Union Carbide, Danbury, CT are also useful. Epoxy resins used in accordance with the invention preferably have epoxide equivalents of from 200 to 700.

The photoimageable composition according to this invention is intended to be hardened to form a permanent innerlayer. Hardening is primarily attributed to the curing of the epoxy resin. To promote sufficiently rapid curing of the epoxy resin, the photoimageable composition of the present invention employs an acidic curative. Acidic cure catalysts include not only substances which have free carboxyl groups, but also chemicals such as anhydrides, which may produce free carboxyl groups. For many applications of the invention, an anhydride, e.g., an anhydride of a multifunctional carboxylic acid is the preferred curative. Other useful catalysts are those having a blocked carboxylic group, which becomes deblocked at a threshold temperature. Epoxy cure catalysts are generally used at levels of from 0.1 to 10 % of the total weight of components (a)-(f).

Although photoimageable compositions used in the process in accordance with the present invention do not necessarily require an additional cross-linking agent, a cross-linking agent (f) is highly desirable. A cross-linking agent is particularly useful in connecting the acrylate chemical system and the epoxy chemical system in a single interconnected network in the innerlayer. Free hydroxyl groups on the epoxy resins and the epoxy- acrylate oligomers, generally provide the basis for such cross-linking. The cross-linking agent (f) is typically used at a level of at least 2 %, 3-5 % being preferred.

In accordance with one aspect of the invention, the cross-linking agent is a melamine-formaldehyde resin. During initial application of the photoimageable composition as a layer, it is believed that the melamine-formaldehyde resin reacts to some extent with the anhydride. This opens the anhydride, providing carboxyl functionality for subsequent epoxy curing. This initial reaction also has a surface drying effect. Melamine/formaldehyde resin acts to cross-link through free hydroxyl groups. The methylol groups of melamine/formaldehyde resins may be alkoxylated to give a suitable cross-linking agent. In accordance with another aspect of the invention, a blocked, multifunctional isocyanate may be used as the cross-linking agent. The blocked isocyanate is selected to deblock generally at the cure temperature of the epoxy resin. An example of a suitable blocked isocyanate is E-caprolactam-blocked isophorone. If a blocked isocyanate is the cross-linking agent and an anhydride is the curative, some preheating of the photoimageable composition at a time prior to cure is desirable. Such preheating opens anhydride species, providing the acid functionality needed to promote curing of the epoxy resin and needed also for alkaline development.

The components of the photoimageable composition are selected to be soluble in a common solvent to form a single-phase liquid composition. The liquid photoimageable composition may be applied to a substrate by a variety of application methods, including screen printing, curtain coating, roller coating and extrusion coating. Each application method has its own particularities, and photoimageable compositions in accordance with this invention may be formulated in accordance with the particular requirements of the particular method of application.

Components (a)-(f) are selected such that a dried composition of these is soluble in alkaline aqueous solution, whereby a layer of the photoimageable composition may be developed in alkaline aqueous solution, e.g., 1% sodium carbonate.

A mixture of components (a)-(f) is typically too viscous to be easily applied as a layer; accordingly, it is generally the practice to dilute the components (a)-(f) with an organic solvent. Typically, solvent is used at a level of 10-60 %, but this will vary depending upon the means of application. For screen printing, solvent is generally used at 10-20%; for electrostatic spray coating, at 20-60%; for curtain coating generally at 40-50%; and for application as a dry film typically about 50%. Suitable solvents include, but are not limited to ethylene glycol monoethyl ether, ethylene glycol monopropyl ether, ethylene glycol monobutyl ether, ethylene glycol-2-ethylhexyl ether, ethylene glycol monohexyl ether, diethylene glycol monomethyl ether, diethylene glycol monoethyl ether, diethylene glycol monopropyl ether, diethylene glycol monobutyl ether, dipropylene glycol methyl ether, propylene glycol monobutyl ether, propylene glycol monopropyl ether, propylene glycol methyl ether, ethylene glycol monoethyl ether acetate, ethylene glycol monobutyl ether acetate, diethylene glycol monoethyl ether acetate, diethylene glycol monobutyl ether acetate, propylene glycol monomethyl ether acetate, ethylene glycol diacetate, 2-ethylhexyl acetate, n-butyl acetate, isobutyl acetate, n-propyl acetate, ethyl acetate, diacetone alcohol, dimethyl formamide, isophorone, diisobutyl ketone, cyclohexanone, isobutyl isobutyrate, methyl n-amyl ketone, amyl acetate, methyl amyl acetone, methyl isoamyl ketone, 2-nitropropane, methyl isobutyl ketone, methyl n-propyl ketone, isopropyl acetate, methyl ethyl ketone, tetrahydrofuran, acetone, methyl acetate, N-methyl pyrolidone and butyrolactone.

In addition to the components described above which are essential to a photoimageable composition of this embodiment the invention, the photoimageable composition may optionally contain additional components which are standard in the art. The photoimageable composition optionally may contain organic or inorganic fillers at levels up to about 35 %. Some examples of fillers are micro talc, ground polyethylene, clay, fumed silica and polyvinylidene fluoride. Also, relatively small amounts of flow-control agents, dyes, antioxidants, etc. may be added. Fillers may effect the final appearance of innerlayers, e.g. provide a matte finish.

The photoimageable compositions will now be described in greater detail by way of specific examples.

## EXAMPLE 1

A composition was prepared as follows:

| Component* | % Wt. |
|---|---|
| Tris(2-hydroxyethyl) isocyanurate triacrylate[1] | 18.7 |
| Methylolated melamine[2] | 3.4 |
| Hetron 912 (epoxy methacrylate resin)[3] | 6.2 |
| Ebecryl 3701 (diacrylate ester of a bisphenol A epoxy resin) [4] | 6.2 |
| Epoxy cresol novolac resin, epoxy eq. 235[5] | 23.8 |
| Bisphenol A epoxy resin, epoxy eq. 575-685[6] | 23.3 |
| 5-(2,5-dioxotetrahydrofuryl)-3-methyl-3-cyclohexene-1,2-dicarboxylic anhydride[7] | 8.6 |
| 2,2-dimethoxy-2-phenyl acetophenone[8] | 1.4 |
| 2-methyl-1-[4-(methylthio)phenyl]-2-(4-morpholinyl)-1-propanone[8] | 6.2 |
| isopropylthioxanthone[9] | 2.3 |
| | 100.0 |
| PLUS Leveling Agents,etc: | |
| Modaflow[10] | 0.9 |
| Byk 361, 306 (equal portions)[11] | 0.8 |
| Malachite green dye[12] | 0.08 |

*Source:
1.Hitachi Corp.;
2.American Cyanamide;
3.Ashland Chemical;
4.Radcure;
5.Ciba-Geigy;
6.Dow;
7.DIC Americas;
8.Ciba-Geigy;
9.Ward Blankensop;
10. Monsanto;
11. Byk Mallinckrodt;
12. Penn;

(continued)

| Component* | % Wt. |
|---|---|
| Filler (fumed silica)[13] | 1.5 |
| Inhibitor (MEHQ)[14] | 0.1 |
| Solvent (Amount and type appropriate to the method of application) | |
| Solvent used: Ethyl-3-ethoxy propionate (EEP)[15] | |

*Source:

13. Cabosil EH5;

14. Aldrich;

15. Kodak

The photoimageable composition was applied as a wet film via a curtain coating process. The following coating conditions were used: 11.1 gm wet coating material per square foot laminate was applied in order to achieve an approximate dry film thickness of 51 to 56 μm (2.0 to 2.2 mils) on laminate and 20 to 23 μm (0.8 to 0.9 mil) dry film thickness on the copper circuitry. Coating speed was 80 to 90 meters per minute. The working viscosity of the photoimageable composition during coating was a Zahn Cup No. 5 reading of 22 seconds, 25°C. This was equivalent to approximately 60 wt. percent solids. The photoimageable composition was dried at 90°C for 15 minutes, and cooled to room temperature. The second side was then coated in a manner identical to the first side. The second side was dried to a tack-free surface at 90°C for 30 minutes. Diazo artwork was placed directly on the film, and the film was exposed to actinic radiation having a UV energy exposure level of at least 350 mjoules/cm$^2$ at the working surface. Exposure time should be such that the exposed portion of the coating remains intact during the aqueous developing process. The film was developed in a basic aqueous solution, i.e., 1% by weight sodium carbonate mono-hydrate. The film was UV-cured by exposure to actinic radiation having a UV energy exposure level of at least 2 joules/cm$^2$. The exposed copper was then etched in a cupric chloride solution (an ammoniacal etchant is an alternative) to generate the circuitry traces. The etched circuit laminates with the innerlayer resist intact are then pressed into a multi-layer board by the "kiss" procedure described above.

EXAMPLE 2

A composition was prepared as follows:

| Component | % Wt. |
|---|---|
| Tris(2-hydroxyethyl) isocyanurate triacrylate | 18.5 |
| Methylolated melamine | 3.4 |
| Hetron 912 | 6.1 |
| Novacure 3701 | 6.1 |
| Epoxy cresol novolac resin, epoxy eq. 235 | 46.7 |
| 5-(2,5-dioxotetrahydrofuryl)-3-methyl-3-cyclohexene-1,2-dicarboxylic anhydride | 8.5 |
| 2,2-dimethoxy-2-phenyl acetophenone | 3.7 |
| 2-methyl-1-[4-(methylthio)phenyl]-2-(4-morpholinyl)-1-propanone | 4.7 |
| isopropylthioxanthone | 2.2 |
| | 99.9 |
| PLUS Leveling Agents, etc: | |
| Byk 361, 306 (equal portions) | 0.8 |
| Pigment (Penn Chips) | 1.0 |
| Filler (precipitated silica, Syloid 72) | 1.5 |
| Inhibitor (MEHQ) | 0.1 |
| Solvent (Amount and type appropriate to the metod application | |
| Solvent used: Ethyl-3-etoxy propionate | |

EXAMPLE 3

Each of the compositions of Examples 1 and 2 were applied as a wet film via an electrostatic spray process as follows:

The photoimageable composition was diluted to a Zahn Cup No. 2 viscosity of 60 seconds using an appropriate solvent. Both sides of the base laminates were coated as they were conveyed at 1.52 m (5 feet) per minute through an aerosol spray of the solution charged via the application of 70,000 volts. Drying of the laminates took place at 80°C for 30 minutes. Diazo artwork was placed directly on the tack-free film and the film was exposed to actinic radiation having a UV energy exposure level of 150 to 400 mjoules/cm$^2$ at the working surface. Exposure time was such that the exposed portion of the coating remained intact during the development of the film in a basic aqueous solution of 1% by weight of sodium carbonate monohydrate. The film was UV-cured by exposure to actinic radiation having a UV energy exposure level of from 1 to 4 joules per cm$^2$. The exposed copper was then etched in a cupric chloride solution to generate the circuitry traces. The etched circuit laminates with the innerlayer resist intact are then pressed into a multi-layer board by the "kiss" procedure described above.

EXAMPLE 4

Each of the compositions of Examples 1 and 2 were applied as a wet film to base sheets so as to form dry films as follows. A wet film of 152 μm (6 mil) thickness was applied by draw down to a base sheet. The solvent evaporated from the film which was then covered with a polyester sheet. The film was applied to a circuit board laminate by hot roll lamination. The diazo artwork was placed on the cover sheet and the film was exposed to actinic radiation having a UV energy exposure level of at least 350 mjoules/cm$^2$ at the working surface. Exposure time was such that the exposed portion of the coating remained intact during the aqueous developing process. The cover sheet was removed from the film before developing. The film was developed in a basic aqueous solution, i.e., 1% by weight sodium carbonate monohydrate. The film was UV-cured by exposure to actinic radiation having a UV energy exposure level of 2 joules/cm$^2$. The exposed copper was then etched in a cupric chloride solution to generate the circuitry traces. The etched circuit laminates with the innerlayer resist intact are then pressed into a multi-layer board by the "kiss" procedure described above.

EXAMPLE 5

A composition was prepared as follows:

| Component | % Wt. |
|---|---|
| Tris(2-hydroxyethyl) isocyanurate triacrylate | 7.8 |
| Pentaerythritol Tetraacrylate (Sartomer) | 5.7 |
| Epoxy cresol novolac resin, epoxy eq. 235 | 37.6 |
| Radcure 3701 | 19.9 |
| E-Caprolactam-blocked isophorone (Diisocyanate based adduct) | 9.7 |
| 5-(2,5-dioxotetrahydrofuryl)-3-methyl-3-cyclohexene-1,2-dicarboxylic anhydride | 10.3 |
| 2,2-dimethoxy-2-phenyl acetophenone | 5.0 |
| 2-methyl-1-[4-(methylthio)phenol]-2-(4-morpholinyl)-1-propanone | 2.8 |
| isopropylthioxanthone | 1.1 |
| | 99.9 |
| PLUS Leveling Agents, etc: | |
|     Bubble Breaker (Witco) | 1.9 |
|     Byk 077 | 2.0 |
|     Byk 306 | 1.1 |
|     Pigment (Penn Green) | 1.2 |
|     Filler (fumed silica, Cabosil EH5) | 3.5 |
|     Inhibitor (MEHQ) | 0.05 |
|     Solvent (Amount and type appropriate to the method of application) | |
|     Solvent used : Ethyl-3-ethoxy propionate, carbitol acetate (1:1). | |

This photoimageable composition was applied as a wet film via screen printing on a printed circuit board. The screen mesh was varied from 61 to 120 mesh. The screened photoimageable composition was dried at 80°C for 30 minutes, providing a non-tacky film. A diazo artwork was placed directly on the film, and the film was exposed to actinic radiation having a UV energy exposure level of 350 mjoules/cm$^2$. The film was developed in a basic aqueous solution, i.e., 1% by weight sodium carbonate monohydrate. The film was UV-cured by exposure to actinic radiation having a UV exposure level of 2 joules/cm$^2$. The exposed copper was then etched in a cupric chloride solution to generate the circuitry traces. The etched circuit laminates with the innerlayer resist intact are then pressed into a multi-layer board by the "kiss" procedure described above.

EXAMPLES 6-8

The photoimageable composition described in Example 5 may also be used in the making of a multi-layered printed circuit board according to the general procedures described in Examples 1 and 3-5.

The performance of rigid multilayer printed circuit boards fabricated with a permanent inner layer photo resist (PILPR) according to the general procedure of Example 1 was measured by test procedures required by the IPC-ML-950-C Performance Specification and MIL-P-55110 General Specification for Printed Wiring Boards. Test coupons of these boards were made to have nominal thicknesses of 2.34, 3.18 and 5.72 mm (0.092, 0.125, and 0.225 inch). The IPC-A-43 comb pattern was imparted to some of the coupons and four-wire plated through hole (PTH) coupons were also tested. In general, it was determined that such boards will meet or exceed the requirements of each specification. Buried layer insulation resistance measurements and high voltage breakdown measurements are conducted on the IPC-A-43 coupons. The high voltage measurements provide a means for detecting delamination of the innerlayers. The PTH test coupon allows measurement of the PTH barrel and interface resistance so that crack initiation and propagation can be detected.

In particular, the boards obtained by the process of this invention meet the standards of the thermal shock test of MIL-P-55110, para. 4.8.6.3, type GF and the thermal stress (solder float) test of IPC-ML-950-C, Class 3, para.4.6.5.1. Said boards exceed the Ionic Contamination requirements of Northern Telecom Corporate Standard 5040.02, Table 5.01 when tested by the method described in Diceon Std. Doc. #108384-026 (Diceon Electronics, Inc.) which is equivalent to methods 2.3.38 and 2.3.39 of IPC-TM-650. A maximum extraction of 1.0 $\mu$g/cm (6.4 $\mu$g/in$^2$) is allowed by those standards and the average value for six boards of this invention was 0.42 $\mu$g/cm$^2$ (2.7 $\mu$g/in$^2$).

**Claims**

1. A process for fabricating a multilayer printed circuit board comprising the steps of:

   (A) providing a plurality of innerlayer boards (10), each comprising a dielectric base (12) and having at least one metal layer (14) thereon;

   (B) coating each of said metal layers with a layer of photoimageable composition (16), which photoimageable composition is curable to form a hard, permanent, dielectric material, and which comprises:

      (a) from 10 to 40% by weight of said polymerizable acrylate monomer;

      (b) from 5 to 35% by weight of an oligomer formed by the reaction of an epoxy resin and acrylic or methacrylic acid;

      (c) a photosensitive, free radical generating initiator for polymerization of the acrylate monomer and oligomer;

      (d) a curable epoxy resin;

      (e) a curing agent for the epoxy resin; and

      (f) from 0% to 15% weight of a cross-linking agent reactive with hydroxyl groups, all based on the total weight of components (a) through (f);

   (C) exposing each of said layers of photoimageable material with patterned actinic radiation;

   (D) developing said exposed layers to remove either exposed or non-exposed portions, leaving non-exposed or exposed portions of said photoimageable composition layers on said metal layers;

   (E) etching said metal layers of said innerlayer boards to remove portions of said metal layers from which said photoimageable composition layer portions were removed; and

(F) without removing remaining portions of said photoimageable composition from said etched metal layers, stacking said innerlayer boards and subjecting said boards to heat and pressure so that said photoimageable composition initially fills voids between the innerlayer boards at least partially and then cures to form hard, permanent, dielectric layers separating circuitry of adjacent innerlayers.

2. A process according to claim 1 wherein the photoimageable composition comprises

(a) from 15 to 35% of the polymerizable acrylate monomer;

(b) from 5 to 25% of the epoxy-acrylate oligomer;

(c) from 3 to 15% of a phosensitive, free radical-generating initiator which in the presence of actinic radiation initiates polymerization of acrylic moieties;

(d) from 30 to 60 wt. percent of an epoxy resin composition which is curable to harden said photoimageable composition subsequent to exposure to actinic radiation;

(e) from 0.1 to 10% of an acidic curative for said epoxy resin; and

(f) from 3 to 5% of the hydroxyl group-reactive cross-linking agent;

said components (a) - (f) being selected so that the composition is soluble in an organic solvent, the solution thus formed being capable of drying to a composition which is soluble in alkaline aqueous solution, whereby said photoimageable composition is developable in aqueous alkaline aqueous solution.

3. A process according to claim 1 or claim 2 which includes the additional step of
(g) connecting the circuitry of the stacked boards.

4. A process according to any preceding claim wherein the acrylate monomer is a triacrylate or trimethacrylate.

5. A process according to claim 4 wherein the acrylate monomer is the triacrylate of tris-(2-hydroxyethyl) isocyanurate.

6. A process according to any preceding claim wherein the epoxy resin (d) has an epoxide equivalent of from 200 to 700.

7. A process according to any preceding claim wherein the amount of the photosensitive, free-radical generating initiator is from 3 to 15% of the total weight of components (a) - (f).

8. A process according to any preceding claim wherein the acyl moiety of the acrylate monomer has the formula: $[RCH=CHC=O]_x$ wherein R is hydrogen or alkyl, and x is an integer of from 1 to 4.


**Patentansprüche**

1. Verfahren zur Herstellung einer mehrschichtigen Platte für eine gedruckte Schaltung mit den Stufen, in denen man

A. mehrere Innenschichtplatten (10) vorsieht, von denen jede eine dielektrische Basis (12) umfaßt und wenigstens eine Metallschicht (14) darauf hat,

B. jede der Metallschichten mit einer durch Licht mit einer Abbildung versehbaren Zusammensetzung (16) überzieht, welche unter Bildung eines harten dauerhaften dielektrischen Materials härtbar ist und welche

a) 10 bis 40 Gew.% des polymerisierbaren Acrylatmonomers,

b) 5 bis 35 Gew. % eines durch Umsetzung eines Epoxyharzes mit Acryl- oder Methacrylsäure gebildeten Oligomers,

c) einen lichtempfindlichen, freie Radikale erzeugenden Initiator für die Polymerisation des Acrylatmonomers und Oligomers,

d) ein härtbares Epoxyharz,

e) ein Härtungsmittel für das Epoxyharz und

f) 0 bis 15 Gew.% eines mit Hydroxylgruppen reaktiven Vernetzungsmittels umfaßt, wobei alle auf der Grundlage des Gesamtgewichtes der Komponenten (a) bis (f) angegeben sind,

C. jede der Schichten von durch Licht mit einer Abbildung versehbaren Materials bildweise mit aktinischer Strahlung belichtet,

D. die belichteten Schichten entwickelt, um entweder belichtete oder nichtbelichtete Bereiche zu entfernen und dabei nichtbelichtete oder belichtete Bereich der durch Licht mit einer Abbildung versehbaren Zusammensetzungsschichten auf den Metallschichten zurückläßt,

E. die Metallschichten der Innenschichtplatten ätzt, um Bereiche der Metallschichten zu entfernen, von welchen Anteile der durch Licht mit einer Abbildung versehbaren Zusammensetzungsschicht entfernt wurden, und

F. ohne Entfernung restlicher Anteile der durch Licht mit einer Abbildung versehbaren Zusammensetzung von den geätzten Metallschichten die Innenschichtplatten aufeinanderschichtet und diese Platten derart Hitze und Druck unterzieht, daß die durch Licht mit Abbildung versehbare Zusammensetzung anfangs Hohlräume zwischen den Innenschichtgrenzen wenigstens teilweise füllt und dann unter Bildung harter, dauerhafter dielektrischer Schichten, die den Schaltkreis benachbarter Innenschichten trennen, aushärtet.

2. Verfahren nach Anspruch 1, bei dem die durch Licht mit Abbildung versehbare Zusammensetzung

a) 15 bis 35 % des polymerisierbaren Acrylatmonomers,

b) 5 bis 25 % des Epoxyacrylatoligomers,

c) 3 bis 15 % eines lichtempfindlichen, freie Radikale erzeugenden Initiators, der in Gegenwart von aktinischer Strahlung eine Polymerisation der Acrylreste einleitet,

d) 30 bis 60 Gew.% einer Epoxyharzzusammensetzung, die härtbar ist, um die durch Licht mit einer Abbildung versehbare Zusammensetzung anschließend an das Belichten mit aktinischer Strahlung zu härten,

e) 0,1 bis 10 % eines sauren Härtungsmittels für das Epoxyharz und

f) 3 bis 5 % des mit Hydroxylgruppen reaktiven Vernetzungsmittels umfaßt,

wobei die Komponenten (a) bis (f) derart ausgewählt sind, daß die Zusammensetzung in einem organischen Lösemittel löslich ist, wobei die so gebildete Lösung zu einer Zusammensetzung trocknen kann, die in alkalischer wäßriger Lösung löslich ist, wobei die durch Licht mit einer Abbildung versehbare Zusammensetzung in wäßriger alkalischer Lösung entwickelbar ist.

3. Verfahren nach Anspruch 1 oder Anspruch 2 mit der zusätzlichen Stufe, in der man
g) den Schaltkreis der übereinandergeschichteten Platten verbindet.

4. Verfahren nach einem der vorausgehenden Ansprüche, bei dem das Acrylatmonomer ein Triacrylat oder Trimethacrylat ist.

5. Verfahren nach Anspruch 4, bei dem das Acrylatmonomer das Triacrylat von tris-(2-Hydroxyethyl)-isocyanurat ist.

6. Verfahren nach einem der vorausgehenden Ansprüche, bei dem das Epoxyharz (d) ein Epoxidäquivalent von 200 bis 700 besitzt.

7. Verfahren nach einem der vorausgehenden Ansprüche, bei dem die Menge des lichtempfindlichen, freie Radikale erzeugenden Initiators 3 bis 15 % des Gesamtgewichtes der Komponenten (a) bis (f) beträgt.

8. Verfahren nach einem der vorausgehenden Ansprüche, bei dem der Acylrest des Acrylatmonomers die Formel $(RCH = CHC = O)_x$ hat, worin R ein Wasserstoffatom oder eine Alkylgruppe ist und x eine ganze Zahl von 1 bis 4 ist.

**Revendications**

1. Procédé de fabrication d'une plaque à circuit imprimé multicouche comprenant les étapes :

(A) de l'apport de plusieurs plaques constituant des couches internes (10), chacune comprenant une base diélectrique (12) et étant surmontée d'au moins une couche métallique (14);
(B) du recouvrement de chacune des dites couches métalliques par une couche d'une composition apte à l'obtention d'une image photo (16), composition apte à l'obtention d'une image photo qui peut être durcie en formant une matière diélectrique permanente, dure, et qui est constituée par :

(a) 10 à 40 % en masse du dit monomère acrylate polymérisable ;
(b) 5 à 35 % en masse d'un oligomère formé par la réaction d'une résine époxy et de l'acide acrylique ou méthacrylique ;
(c) un initiateur photosensible, générant des radicaux libres, pour la polymérisation du monomère acrylate et de l'oligomère ;
(d) une résine époxy durcissable ;
(e) un agent durcisseur pour la résine époxy ; et
(f) 0 à 15 % en masse d'un agent réticulant réactif vis-à-vis des groupes hydroxyle, tous exprimés par rapport à la masse totale des composants (a) à (f).

(C) de l'exposition de chacune des dites couches de matière apte à l'obtention d'une image photo à un rayonnement actinique formant un motif;
(D) du développement des dites couches exposées pour enlever soit les parties exposées, soit les parties non exposées, et laisser les parties non-exposées ou exposées des dites couches de composition apte à l'obtention d'une image photo sur lesdites couches métalliques ;
(E) de l'attaque des dites couches métalliques des dites plaques constituant des couches internes pour enlever les parties des dites couches métalliques desquelles ont été enlevées les parties de couches de composition apte à l'obtention d'une image photo ; et
(F) sans enlever les parties de composition apte à l'obtention d'une image photo restantes sur lesdites couches métalliques attaquées, d'empilement des dites plaques constituant des couches internes et de traitement des dites plaques par la chaleur et la pression, de telle façon que ladite composition apte à l'obtention d'une image photo remplisse d'abord les vides entre les plaques constituant des couches internes au moins partiellement, puis durcisse en formant des couches diélectriques permanentes, dures, séparant les circuits des couches internes adjacentes.

2. Procédé selon la revendication 1, dans lequel la composition apte à l'obtention d'une image photo est constituée par

(a) 15 à 35 % du monomère acrylate polymérisable ;
(b) 5 à 25 % d'oligomère époxy-acrylate;
(c) 3 à 15 % d'un initiateur photosensible, générant des radicaux libres, qui, en présence d'un rayonnement actinique, initie la polymérisation de fragments acryliques ;
(d) 30 à 60 % d'une composition de résine époxy durcissable, pour durcir ladite composition apte à l'obtention d'une image photo après l'exposition au rayonnement actinique ;
(e) 0,1 à 10 % d'un agent durcisseur acide pour ladite résine époxy ; et
(f) 3 à 5 % de l'agent réticulant réactif vis-à-vis des groupes hydroxyle ;

lesdits composants (a) - (f) étant choisis de telle sorte que la composition soit soluble dans un solvant organique, la solution ainsi formée étant capable de sécher pour donner une composition soluble dans une solution aqueuse basique, ladite composition apte à l'obtention d'une image photo étant développable dans une solution aqueuse basique.

3. Procédé selon la revendication 1 ou la revendication 2, qui comprend l'étape supplémentaire de

(g) la connexion des circuits des plaques empilées.

**4.** Procédé selon une quelconque des revendications qui précèdent, dans lequel le monomère acrylate est un triacrylate ou un triméthacrylate.

**5.** Procédé selon la revendication 4, dans lequel le monomère acrylate est le triacrylate du tris-(2-hydroxyéthyl)isocyanurate.

**6.** Procédé selon une quelconque des revendications qui précèdent, dans lequel la résine époxy (d) a un équivalent époxy situé entre 200 et 700.

**7.** Procédé selon une quelconque des revendications qui précèdent, dans lequel la quantité d'initiateur photosensible, générant des radicaux libres est située entre 3 et 15 % par rapport à la masse totale des composants (a) à (f).

**8.** Procédé selon une quelconque des revendications qui précèdent, dans lequel le fragment acyle du monomère acrylate a pour formule : $[RCH{=}CHC{=}O]_x$ dans laquelle R est l'hydrogène ou un alkyle, et x est un entier allant de 1 à 4.

FIG. I

# FIG.2

EP 0 570 094 B1